(19) Europäisches Patentamt
European Patent Office
Office européen des brevets

(11) **EP 4 256 276 B1**

(12) **EUROPEAN PATENT SPECIFICATION**

(45) Date of publication and mention
of the grant of the patent:
**16.10.2024 Bulletin 2024/42**

(21) Application number: **21824420.0**

(22) Date of filing: **20.11.2021**

(51) International Patent Classification (IPC):
**G01D 5/20** (2006.01)

(52) Cooperative Patent Classification (CPC):
**G01D 5/204**

(86) International application number:
**PCT/FI2021/050795**

(87) International publication number:
**WO 2022/117913 (09.06.2022 Gazette 2022/23)**

(54) **A VARIABLE RELUCTANCE POSITION SENSOR**

POSITIONSSENSOR MIT VARIABLER RELUKTANZ

CAPTEUR DE POSITION À RÉLUCTANCE VARIABLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.12.2020 FI 20206254**

(43) Date of publication of application:
**11.10.2023 Bulletin 2023/41**

(73) Proprietor: **Lappeenrannan-Lahden teknillinen
yliopisto LUT**
**53851 Lappeenranta (FI)**

(72) Inventors:
• **ABRAMENKO, Valerii**
**53851 Lappeenranta (FI)**
• **PETROV, Ilya**
**53851 Lappeenranta (FI)**
• **PYRHÖNEN, Juha**
**53851 Lappeenranta (FI)**

(74) Representative: **Väänänen, Janne Kalervo**
**Vanarix Oy**
**Laaksolahdentie 74**
**02730 Espoo (FI)**

(56) References cited:
**EP-A1- 3 324 523          EP-A1- 3 468 016
JP-A- 2000 314 606      JP-A- 2019 032 201
US-A1- 2004 007 926    US-A1- 2019 280 537**

EP 4 256 276 B1

## Description

### Technical field

The disclosure relates to a variable reluctance position sensor that can be, for example not necessarily, a variable reluctance resolver for producing signals indicative of a rotation angle of a rotating object such as e.g. a rotor of an electric machine. For another example, the variable reluctance position sensor can be a sensor configured measure a position of a moving object such as e.g. a mover of a linear electric machine.

### Background

A variable reluctance "VR" position sensor comprises excitation coils and detection coils in a first element and no coils in a second element which is movable with respect to the first element and whose position with respect to the first element is to be measured. Thus, there is no need to conduct electric current to the moving second element. A variable reluctance position sensor can be for example a variable reluctance resolver in which the above-mentioned first element is a stator and the above-mentioned second element is a rotor whose rotation angle with respect to the stator is to be measured. A significant advantage of a variable reluctance resolver is that there is no need to conduct electric current to the rotor. A stator of a variable reluctance resolver receives an alternating excitation signal to excitation coils and produces first and second alternating output signals by first and second detection coils, respectively, wherein amplitudes of the first and second alternating output signals are dependent on the rotational position of the resolver so that envelopes of the first and second alternating output signals i.e. curves outlining extremes of the first and second alternating output signals have a mutual phase shift.

The publication US20130162243 describes a variable reluctance resolver that comprises a ring-like stator, a rotor, and a housing. The stator comprises a stator core and coils. The stator core is provided with plural salient poles. The coils are wound to the salient poles of the stator. The housing accommodates the stator. The rotor comprises an airgap surface having a profile formed with plural arc-like convex portions that deviate from a circular shape and are located at equal spaces in the circumferential direction. The number of the arc-like convex portions is the ratio of 360 degrees, i.e. a full circle, to the center angle of a measurement sector of the variable reluctance resolver. In a case where the variable reluctance resolver is used for measuring a rotational angle a rotor of an electric machine, the number of the above-mentioned arc-like convex portions can be e.g. the same as the number of pole-pairs of the electric machine, and thereby the variable reluctance resolver measures the rotational position of the rotor of the electric machine as electrical degrees. It is also possible that the number of pole-pairs of the electric machine is a multiple of the number of the arc-like convex portions. In this exemplifying case, the angle measured with the variable reluctance resolver is to be multiplied by this multiple number to obtain the rotational position of the rotor of the electric machine as electrical degrees of the electric machine.

A variable reluctance resolver of the kind described above is however not free from challenges. One of the challenges is related to cases in which a variable reluctance resolver is used for measuring a rotation angle of a rotor of an electric machine that has very many pole-pairs. In an exemplifying case where the number of the arc-like convex portions of the rotor of the variable reluctance resolver is the same as the number of pole-pairs of the electric machine, the center angle of a measurement sector of the variable reluctance resolver is small in mechanical degrees and thus the pole pitch in the stator of the variable reluctance resolver must be small in mechanical degrees to achieve a sufficient measurement accuracy in electrical degrees. This may lead to a situation in which the circumference of the stator of the variable reluctance resolver has very many stator teeth, and thereby the variable reluctance resolver is complex and expensive. In another exemplifying case where the number of pole-pairs of the electric machine is a multiple of the number of the arc-like convex portions, a sensing position error is increasing when the measured resolver angle is multiplied by this multiple number to obtain the rotational position of the rotor of the electric machine as electrical degrees of the electric machine.

EP 3 324 523 A1, US 2004/007926 A1 and US 2019/280537 A1 are further known examples of variable reluctance position sensors.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments.

In this document, the word "geometric" when used as a prefix means a geometric concept that is not necessarily a part of any physical object. The geometric concept can be for example a geometric point, a straight or curved geometric line, a planar or non-planar geometric surface, a geometric space, or any other geometric entity that is zero, one, two, or three dimensional.

In accordance with the invention, there is provided a new variable reluctance position sensor that can be for example a variable reluctance resolver for measuring a rotational angle of a rotating object. It is however also possible that a variable reluctance position sensor according to an embodiment of the invention is configured to measure a position of a linearly moving object.

A variable reluctance position sensor according to the invention comprises:

- a first element comprising a plurality of magnetic sensor sections, and

- a second element moveable with respect to the first element and comprising an air-gap surface having a periodically meandering profile with at least two spatial meandering periods,

wherein:

- each of the magnetic sensor sections is configured to conduct a magnetic flux to and from the second element via the airgap surface of the second element, and

- first ones of the magnetic sensor sections comprise first excitation coils and first detection coils configured to produce a first alternating output signal when alternating excitation signal is supplied to the first excitation coils, and

- second ones of the magnetic sensor sections comprise second excitation coils and second detection coils configured to produce a second alternating output signal when the alternating excitation signal is supplied to the second excitation coils, amplitudes of the first and second alternating output signals being dependent on a position of the second element with respect to the first element so that envelopes of the first and second alternating output signals have a phase-shift with respect to each other.

The above-mentioned first ones of the magnetic sensor sections constitute a first group of successively placed magnetic sensor sections and the above-mentioned second ones of the magnetic sensor sections constitute a second group of successively placed magnetic sensor sections so that the second group is displaced with respect to the first group by C $\times$ the spatial meandering period, where C is a non-integer number. In exemplifying cases in which C = ¼ + an integer, the phase-shift between the envelopes of the first and second alternating output signals is 90 degrees, i.e. $\pi/2$.

In a variable reluctance position sensor according to an exemplifying and non-limiting embodiment, the first group of successively placed magnetic sensor sections covers less than the spatial meandering period, and correspondingly the second group of successively placed magnetic sensor sections covers less than the spatial meandering period.

In a variable reluctance position sensor according to an exemplifying and non-limiting embodiment, the first group of successively placed magnetic sensor sections covers less than 2 $\times$ the spatial meandering period, and correspondingly the second group of successively placed magnetic sensor sections covers less than 2 $\times$ the spatial meandering period.

In an exemplifying case where a variable reluctance position sensor according to an exemplifying and non-limiting embodiment is a variable reluctance resolver that is used for measuring a rotational angle of an electric machine having many pole-pairs, the stator of the variable reluctance resolver does not need to cover 360 mechanical degrees, but the first group of successively placed magnetic sensor sections covers advantageously less than one pole pair pitch, i.e. less than 360 electrical degrees, of the electric machine and correspondingly the second group of successively placed magnetic sensor sections covers advantageously less than one pole pair pitch of the electric machine.

Various exemplifying and non-limiting embodiments are described in accompanied dependent claims.

Exemplifying and non-limiting embodiments both as to constructions and to methods of operation, together with additional objects and advantages thereof, will be best understood from the following description of specific exemplifying and non-limiting embodiments when read in conjunction with the accompanying drawings.

The verbs "to comprise" and "to include" are used in this document as open limitations that neither exclude nor require the existence of unrecited features. The features recited in dependent claims are mutually freely combinable unless otherwise explicitly stated. Furthermore, it is to be understood that the use of "a" or "an", i.e. a singular form, throughout this document does not exclude a plurality.

**Brief description of the figures**

Exemplifying and non-limiting embodiments and their advantages are explained in greater detail below in the sense of examples and with reference to the accompanying drawings, in which:

figure 1 illustrates a variable reluctance position sensor according to an exemplifying and non-limiting embodiment,

figures 2a and 2b illustrate a variable reluctance position sensor according to an exemplifying and non-limiting embodiment,

figures 3a and 3b illustrate a variable reluctance position sensor according to an exemplifying and non-limiting embodiment,

figure 4a illustrates a variable reluctance position sensor according to an exemplifying and non-limiting embodiment,

figures 4b and 4c show exemplifying signals obtained with the variable reluctance position sensor illustrated in figure 4a,

figure 4d shows a positioning error related to the variable reluctance position sensor illustrated in figure 4a,

figure 4e shows a positioning error related to a modification of the variable reluctance position sensor illustrated in figure 4a,

figure 5 illustrates a variable reluctance resolver according to an exemplifying and non-limiting embodiment, and

figures 6 and 7 illustrate variable reluctance resolvers according to exemplifying and non-limiting embodiments.

## Description of the exemplifying and non-limiting embodiments

The specific examples provided in the description below should not be construed as limiting the scope and/or the applicability of the accompanied claims. Lists and groups of examples provided in the description are not exhaustive unless otherwise explicitly stated.

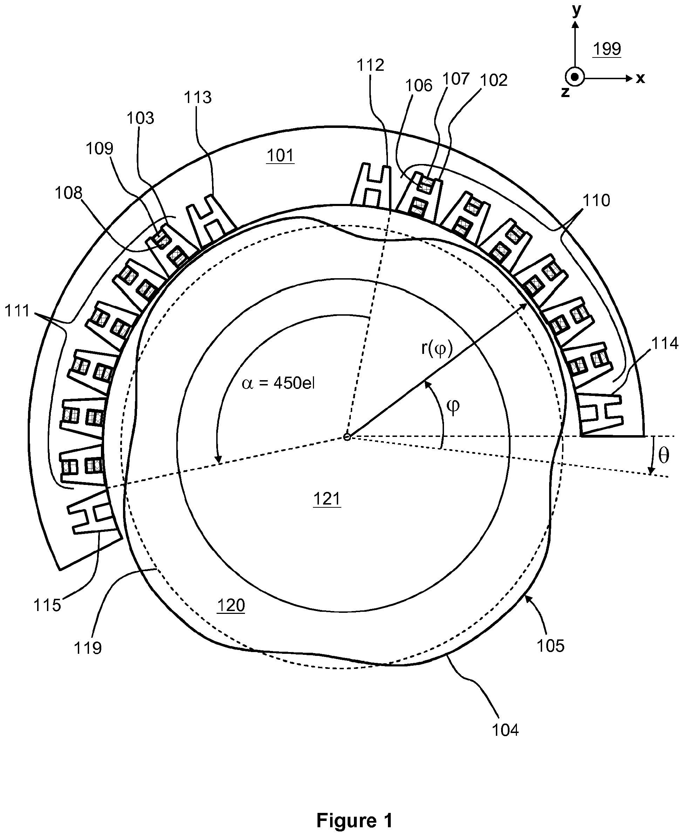

Figure 1 illustrates a variable reluctance position sensor according to an exemplifying and non-limiting embodiment. The variable reluctance position sensor comprises a first element 101 and a second element 104. In this exemplifying case, the variable reluctance position sensor is a variable reluctance resolver for measuring a rotational angle $\theta$ of the second element 104 with respect to the first element 101. The rotational axis of the second element 104, i.e. a rotor, is parallel with the z-axis of a coordinate system 199. The second element 104, i.e. the rotor, comprises an airgap surface 105 that has a periodically meandering profile with four spatial meandering periods. In this exemplifying case, the first element 101, i.e. a stator, comprises a plurality of magnetic sensor sections that are placed along an arc of a geometric circle in a direction of movement of the airgap surface 105. In figure 1, two of the magnetic sensor sections are denoted with references 102 and 103. As shown in figure 1, the profile of the air-gap surface 105 meanders with respect to a geometric circle 116 so that a radius r is a periodic function of a center angle $\varphi$ that is defined with respect to a reference direction fixed to the second element 104. The radius r can be for example $r(\varphi) = R_0 + R_1\sin(4(\varphi + \gamma))$, where $R_0$, $R_1$, and $\gamma$ are constants. A part 120 of the second element 104 may comprise electrically insulated ferromagnetic sheets stacked in the axial direction of the second element 104, i.e. in the z-direction of the coordinate system 199. It is also possible that the part 120 is made of e.g. ferrite or soft magnetic composite such as e.g. SOMALOY®. A center part 121 of the second element 104 can be made of e.g. solid steel.

Each of the magnetic sensor sections of the first element 101 is configured to conduct a magnetic flux to and from the second element 104 via the airgap surface 105 of the second element. First ones of the magnetic sensor sections constitute a first group 110 of equidistantly successively placed magnetic sensor sections and second ones of the magnetic sensor sections constitute a second group 111 of equidistantly successively placed magnetic sensor sections. The first ones of the magnetic sensor sections comprise first excitation coils and first detection coils configured to produce a first alternating output signal when alternating excitation signal is supplied to the first excitation coils. In figure 1, one of the first excitation coils is denoted with a reference 106 and one of the first detection coils is denoted with a reference 107. Correspondingly, the second ones of the magnetic sensor sections comprise second excitation coils and second detection coils configured to produce a second alternating output signal when alternating excitation signal is supplied to the second excitation coils. In figure 1, one of the second excitation coils is denoted with a reference 108 and one of the second detection coils is denoted with a reference 109. Amplitudes of the first and second alternating output signals are dependent on the rotation angle $\theta$ of the second element 104 with respect to the first element 101 so that envelopes of the first and second alternating output signals, i.e. curves outlining extremes of the first and second alternating output signals, have a phase-shift with respect to each other.

The first group 110 of successively placed magnetic sensor sections and the second group 111 of successively placed magnetic sensor sections are mechanically arranged so that the second group 111 is displaced with respect to the first group 110 in a direction of movement of the airgap surface 105, i.e. in the circumferential direction, by C × the spatial meandering period, where C is a non-integer number. In this exemplifying case, C = 1¼. With this exemplifying displacement between the first and second groups 110 and 111, the phase-shift between the envelopes of the first and second alternating output signals is substantially 90 degrees. In the exemplifying variable reluctance position sensor illustrated in figure 1, the second element has four mechanical poles, i.e. the meandering period is 90 mechanical degrees which corresponds to 360 electrical degrees. In this exemplifying case, the second group 111 is displaced with respect to the first group 110 by 90 electrical degrees + 360 electrical degrees = 450 electrical degrees, i.e. 112.5 mechanical degrees. In the exemplifying case illustrated in figure 1, the first group 110 covers about 300 electrical degrees i.e. 75 mechanical degrees and correspondingly the second group 111 covers about 300 electrical degrees i.e. 75 mechanical degrees.

In the exemplifying variable reluctance resolver illustrated in figure 1, the first and second groups 110 and 111 are circumferentially successive. In this case, the axial length i.e. the z-directional length of the variable reluctance resolver can be minimized. It is however also possible that the first and second groups 110 and 111 are axially successive and the first and second groups 110 and 111 are overlapping when seen along an axial direction i.e. along the z-axis of the coordinate system 199. In this exemplifying case, the second group 111 can be circumferentially displaced with respect to the first group 110 by only 90 electrical degrees i.e. by 22.5 mechanical degrees, i.e. by ¼ × the spatial meandering period.

In a variable reluctance position sensor according to an exemplifying and non-limiting embodiment, the number of the magnetic sensor sections of the first group 110 of successively placed magnetic sensor sections is N, and:

$$N_s(i) = (-1)^i \, N_{s0} \sin [2\pi \, (i - \tfrac{1}{2})/(N)], \quad i = 1, \ldots, N, \tag{1}$$

where $N_{s0}$ is a predetermined integer, the absolute value of $N_s(i)$ is the number of turns of the first detection coil in $i^{th}$ one of the magnetic sensor sections of the first group 110 and the sign of the $N_s(i)$ is indicative of a winding direction of the first detection coil in the $i^{th}$ one of the magnetic sensor sections of the first group. The first detection coils are advantageously series connected. In this exemplifying case, the first excitations coils can be for example such that:

$$N_e(i) = (-1)^i \, N_{e0}, \quad i = 1, \ldots, N, \tag{2}$$

where $N_{e0}$ is a predetermined integer, the absolute value of $N_e(i)$ is the number of turns of the first excitation coil in $i^{th}$ one of the magnetic sensor sections of the first group 110, and the sign of $N_e(i)$ is indicative of a winding direction of the first excitation coil in the $i^{th}$ one of the magnetic sensor sections of the first group. The first excitation coils are advantageously series connected. The magnetic sensor sections can be numbered for example so that the index i increases in the counterclockwise direction. The second group 111 of successively placed magnetic sensor sections is advantageously like the first group of successively placed magnetic sensor sections.

In a variable reluctance position sensor according to the above-described exemplifying and non-limiting embodiment, the envelope of the first alternating output signal produced by the first detection coils of the first group 110 is proportional to the sine of the rotation angle θ, i.e. sin(θ), and the envelope of the second alternating output signal produced by the second detection coils of the second group 111 is proportional to the cosine of the rotation angle θ, i.e. cos(θ).

In the exemplifying variable reluctance resolver illustrated in figure 1:

$$N_s(i) = (-1)^i \, N_{s0} \sin [2\pi \, (i - \tfrac{1}{2})/6], \quad i = 1, 2, \ldots, 6, \text{ and} \tag{3}$$

$$N_e(i) = (-1)^i \, N_{e0}, \quad i = 1, 2, \ldots, 6. \tag{4}$$

In the exemplifying variable reluctance resolver illustrated in figure 1, the first and second excitation coils change the polarity in each next magnetic sensor section, which corresponds to the above-presented equations 1-4, i.e. the part $(-1)^i$ in these equations. However, there can be any kind of orientation of the first and second excitation coils, while the orientation of the first and second detection coils is to be adjusted appropriately to obtain e.g. sine and cosine output signals. Below-presented equations correspond to an exemplifying case in which all the excitation coils have a same winding direction:

$$N_s(i) = N_{s0} \sin [2\pi (i - \tfrac{1}{2})/(N)], \quad i = 1, ..., N, \tag{5}$$

$$N_e(i) = N_{e0}, \quad i = 1, ..., N. \tag{6}$$

The variables and parameters in equations 5 and 6 are the same as in equations 1 and 2.

In the exemplifying variable reluctance resolver illustrated in figure 1, the first element 101 comprises electrically and/or magnetically conductive elements 112 and 113 between the first and second groups 110 and 111 of successively placed magnetic sensor sections. The term "magnetically conductive" means that the relative magnetic permeability $\mu$ of material of the electrically and/or magnetically conductive elements is greater than one. The electrically and/or magnetically conductive elements can be for example electrically conductive and/or ferromagnetic. The exemplifying variable reluctance resolver illustrated in figure 1 comprises an electrically and/or magnetically conductive element 114 at an end of the first group 110 facing away from the second group 111, and an electrically and/or magnetically conductive element 115 at an end of the second group 111 facing away from the first group 110.

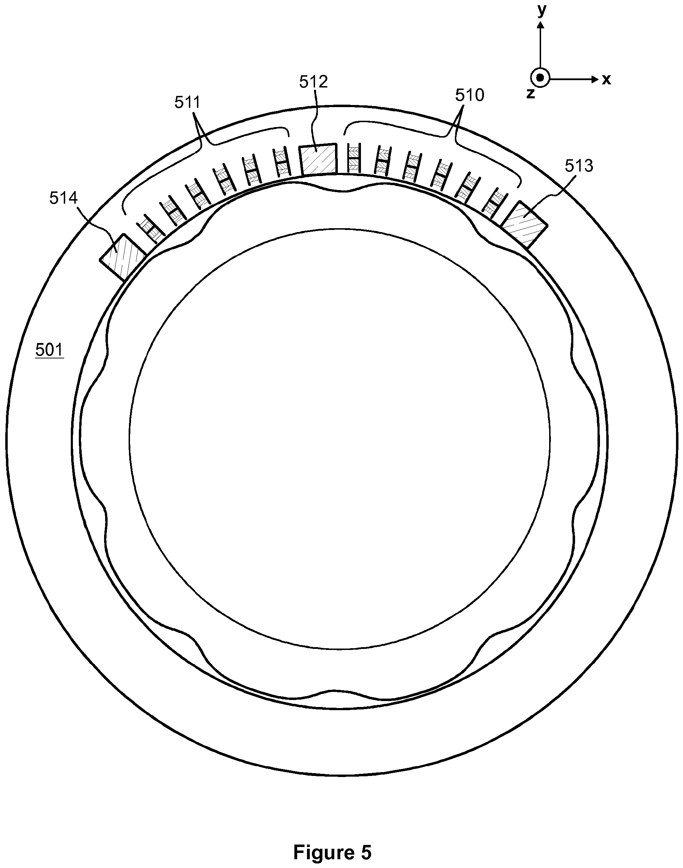

In the exemplifying variable reluctance resolver illustrated in figure 1, each of the magnetic sensor sections has a magnetic core element that is separate with respect to magnetic core elements of other ones of the magnetic sensor sections, and each of the electrically and/or magnetically conductive elements 112-115 has the same shape as the magnetic core elements of magnetic sensor sections. It is also possible that the electrically and/or magnetically conductive elements have a different shape. Figure 5 illustrates a variable reluctance resolver according to an exemplifying and non-limiting embodiment in which the first element 501 comprises electrically and/or magnetically conductive elements 512, 513, and 514 which have a shape different from the shape of the magnetic core elements of the magnetic sensor sections. It is to be noted that the electrically and/or magnetically conductive elements can be of any suitable shape that can be found e.g. with experiments and/or simulations.

According to experiments and simulations, an advantage of the electrically and/or magnetically conductive elements is that the electrically and/or magnetically conductive element 512 reduces unwanted magnetic interactions that would otherwise take place between those of the magnetic sensor sections of the first and second groups 510 and 511 which are nearest to each other. Once the electrically and/or magnetically conductive element 512 is placed between the first and second groups 510 and 511, it is advantageous to place the other electrically and/or magnetically conductive elements 513 and 514 to the other ends of the first and second groups 510 and 511 to avoid asymmetry within each of the first and second groups 510 and 511. Naturally, if the magnetic sensor sections of the first and second groups and are placed far enough from each other, there is no need to install electrically and/or magnetically conductive elements at all because the magnetic sensor sections belonging to different groups cannot interact with each other. Each of the electrically and/or magnetically conductive elements can be made of for example aluminum, solid or laminated steel, ferrite, soft magnetic composite such as e.g. SOMALOY®, or some other suitable electrically and/or magnetically conductive material.

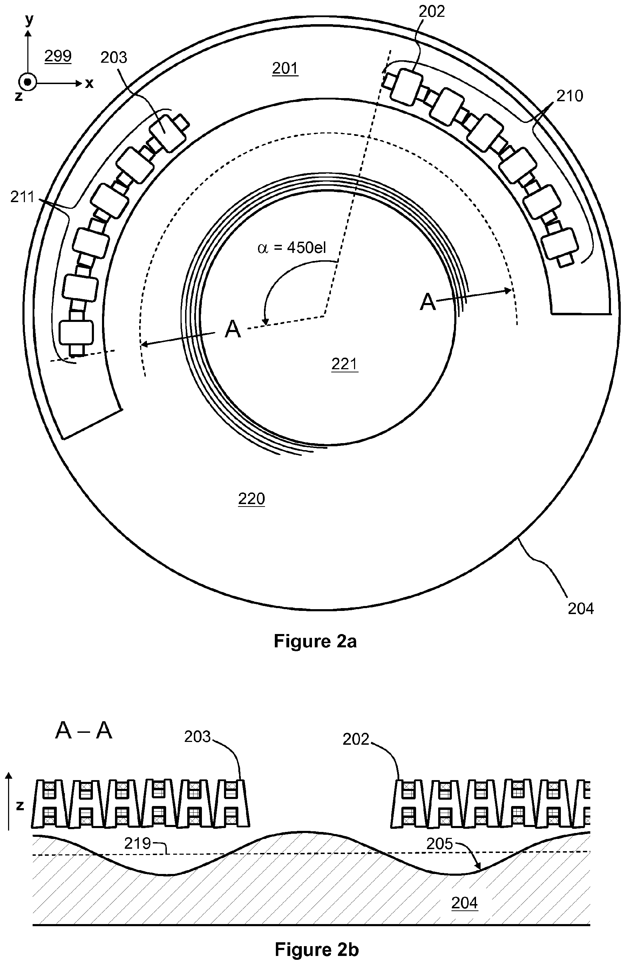

In the exemplifying variable reluctance resolver illustrated in figure 1, the airgap surface 105 of the second element 104, i.e. the rotor, faces radially towards the first element 101, i.e. the stator. Figures 2a and 2b illustrate a variable reluctance resolver according to another exemplifying and non-limiting embodiment. Figure 2a shows the variable reluctance resolver when seen along the negative z-direction of a coordinate system 299, and figure 2b shows a section taken along a geometric arc A-A shown in figure 2a. The variable reluctance resolver comprises a first element 201 that is a stator of the variable reluctance resolver, and a second element 204 that is a rotor of the variable reluctance resolver. The rotational axis of the second element 204, i.e. the rotor, is parallel with the z-axis of the coordinate system 299. The stator comprises a plurality of magnetic sensor sections that are placed along an arc of a geometric circle. In figures 2a and 2b, two of the magnetic sensor sections are denoted with references 202 and 203. The rotor comprises an air-gap surface 204 that has a periodically meandering profile with four spatial meandering periods. In this exemplifying case, the airgap surface 205 of the rotor faces axially towards the stator and the rotor and the stator are axially successive. As shown in figure 2b, the profile of the air-gap surface 205 meanders with respect to a geometric plane 219 that is perpendicular to the z-axis of the coordinate system 299. A part 220 of the rotor may comprise a roll of electrically insulated ferromagnetic sheet so that the geometric axis of the roll coincides with the geometric axis of rotation of the rotor. It is also possible that the part 220 is made of e.g. ferrite or soft magnetic composite such as e.g. SOMALOY®. A center part 221 of the rotor can be made of e.g. solid steel.

First ones of the magnetic sensor sections constitute a first group 210 of equidistantly successively placed magnetic sensor sections and second ones of the magnetic sensor sections constitute a second group 211 of equidistantly successively placed magnetic sensor sections. The first ones of the magnetic sensor sections comprise first excitation coils and first detection coils configured to produce a first alternating output signal when alternating excitation signal is supplied to the first excitation coils. Correspondingly, the second ones of the magnetic sensor sections comprise second excitation coils and second detection coils configured to produce a second alternating output signal when alternating excitation signal is supplied to the second excitation coils. The first group 210 of successively placed magnetic sensor sections and the second group 211 of successively placed magnetic sensor sections are mechanically arranged so that the second group 211 is displaced with respect to the first group 210 in a direction of movement of the airgap surface 205, i.e. in the circumferential direction, by C × the spatial meandering period, where C is a non-integer number. In the exemplifying case illustrated in figures 2a and 2b, C = 1¼.

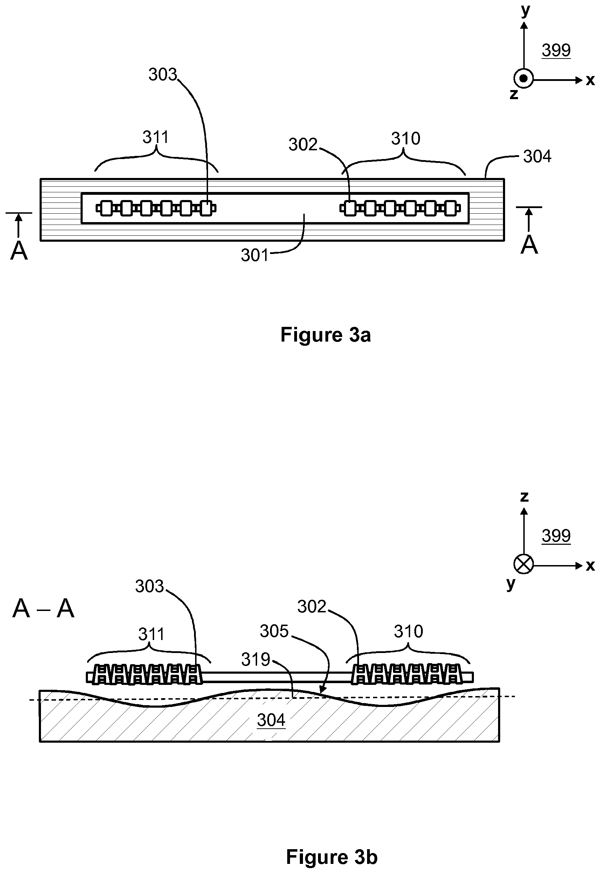

Figures 3a and 3b illustrate a variable reluctance position sensor according to an exemplifying and non-limiting embodiment. The variable reluctance position sensor comprises a first element 301 and a second element 304. In this exemplifying case, the variable reluctance position sensor is a linear position sensor configured measure a position of the second element 304 with respect to the first element 301 in the x-direction of a coordinate system 399. Figure 3a shows the linear position sensor when seen along the negative z-direction of the coordinate system 399, and figure 3b shows a section taken along a line A-A shown in figure 3a. The geometric section plane is parallel with the xz-plane of the coordinate system 399. The first element 301 comprises a plurality of magnetic sensor sections that are placed along a geometric line. In figures 3a and 3b, two of the magnetic sensor sections are denoted with references 302 and 303. The second element 304 comprises an air-gap surface 305 that has a periodically meandering profile with two spatial meandering periods. As shown in figure 3b, the profile of the air-gap surface 305 meanders with respect to a geometric plane 319 that is perpendicular to the z-axis of the coordinate system 399.

First ones of the magnetic sensor sections constitute a first group 310 of equidistantly successively placed magnetic sensor sections and second ones of the magnetic sensor sections constitute a second group 311 of equidistantly successively placed magnetic sensor sections. The first ones of the magnetic sensor sections comprise first excitation coils and first detection coils configured to produce a first alternating output signal when alternating excitation signal is supplied to the first excitation coils. Correspondingly, the second ones of the magnetic sensor sections comprise second excitation coils and second detection coils configured to produce a second alternating output signal when alternating excitation signal is supplied to the second excitation coils. The first group 310 of successively placed magnetic sensor sections and the second group 311 of successively placed magnetic sensor sections are mechanically arranged so that the second group 311 is displaced with respect to the first group 310 in a direction of movement of the airgap surface 305 by C × the spatial meandering period, where C is a non-integer number. In the exemplifying case illustrated in figures 3a and 3b, C = 1¼.

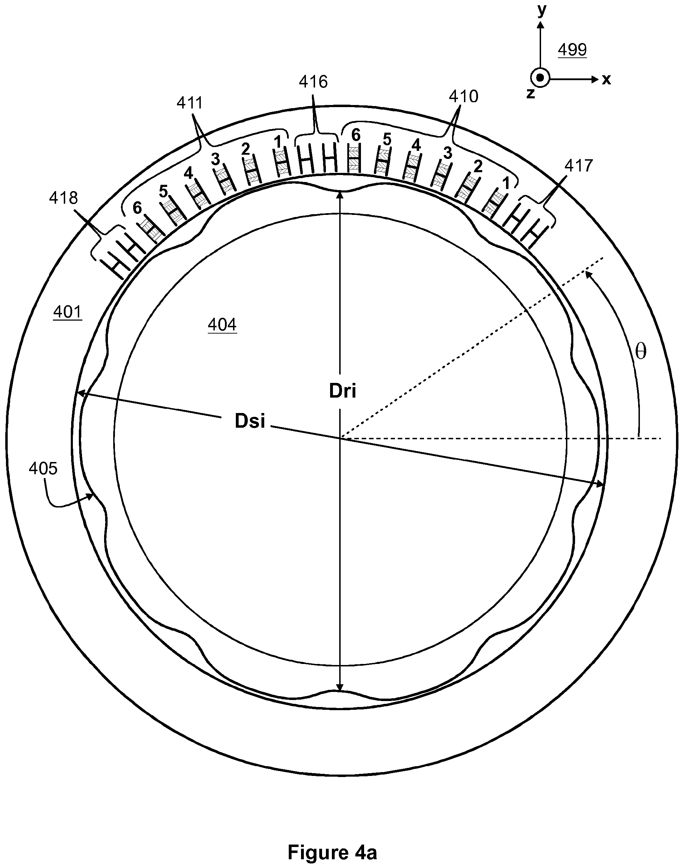

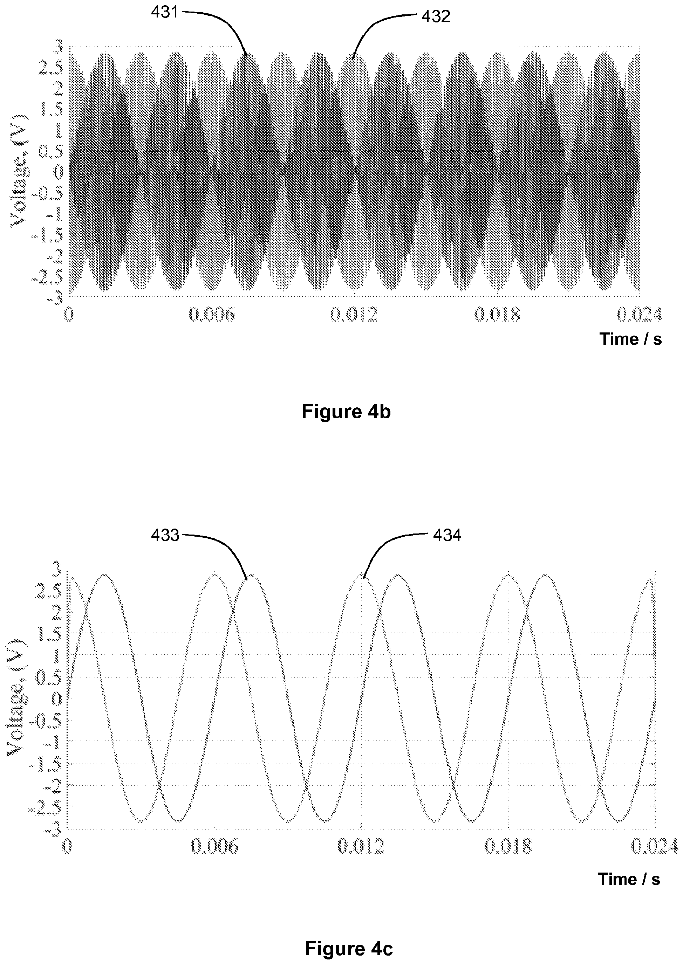

Figure 4a illustrates a variable reluctance position sensor according to an exemplifying and non-limiting embodiment. The variable reluctance position sensor comprises a first element 401 and a second element 404. In this exemplifying case, the variable reluctance position sensor is a variable reluctance resolver for measuring a rotational angle θ of the second element 404, i.e. a rotor, with respect to the first element 401, i.e. a stator. The rotational axis of the second element 404, i.e. the rotor, is parallel with the z-axis of a coordinate system 499. The first element 401, i.e. the stator, comprises a plurality of magnetic sensor sections that are placed along an arc of a geometric circle. The second element 404, i.e. the rotor, comprises an air-gap surface 405 that has a periodically meandering profile with ten spatial meandering periods, i.e. the rotor comprises ten mechanical poles. First ones of the magnetic sensor sections constitute a first group 410 of equidistantly successively placed magnetic sensor sections and second ones of the magnetic sensor sections constitute a second group 411 of equidistantly successively placed magnetic sensor sections. The first ones of the magnetic sensor sections comprise first excitation coils and first detection coils configured to produce a first alternating output signal when alternating excitation signal is supplied to the first excitation coils. Correspondingly, the second ones of the magnetic sensor sections comprise second excitation coils and second detection coils configured to produce a second alternating output signal when alternating excitation signal is supplied to the second excitation coils. The first group 410 of successively placed magnetic sensor sections and the second group 411 of successively placed magnetic sensor sections are mechanically arranged so that the second group 411 is displaced with respect to the first group 410 in a direction of movement of the airgap surface 405, i.e. in the circumferential direction, by C × the spatial meandering period, where C is a non-integer number. In the exemplifying variable reluctance resolver illustrated in figure 4a, C = 1¼. In other words, the second group 411 is displaced with respect to the first group 410 by 90 electrical degrees + 360 electrical degrees i.e. by 450 electrical degrees which is 45 mechanical degrees. With this displacement between the first and second groups 410 and 411, the phase-shift between the envelopes of the first and second alternating output signals is substantially 90 degrees. Each spatial meandering period of the airgap surface 405 represents one full period of each of the above-mentioned envelopes.

In the exemplifying variable reluctance resolver illustrated in figure 4a, the first element 401 comprises electrically and/or magnetically conductive elements 416 between the first and second groups 410 and 411 of successively placed magnetic sensor sections. Furthermore, the exemplifying variable reluctance resolver comprises electrically and/or magnetically conductive elements 417 at an end of the first group 410 facing away from the second group 411, and electrically and/or magnetically conductive elements 418 at an end of the second group 411 facing away from the first group 410. Each of the magnetic sensor sections has a magnetic core element that is separate with respect to magnetic core elements of other ones of the magnetic sensor sections. In the exemplifying case shown in figure 4a, each of the electrically and/or magnetically conductive elements has the same shape as the magnetic core elements of magnetic sensor sections. The electrically and/or magnetically conductive elements can be made of e.g. aluminum, solid or laminated steel, ferrite, soft magnetic composite such as e.g. SOMALOY®, or some other suitable electrically and/or magnetically conductive material.

In the exemplifying variable reluctance position sensor illustrated in figure 4a, the first detection coils can be configured according to the earlier presented equation 1:

$$N_s(i) = (-1)^i N_{s0} \sin [2\pi (i - \tfrac{1}{2})/(N)], \; i = 1, \ldots, N,$$

where N is the number of the magnetic sensor sections in the first group 410, $N_{s0}$ is a predetermined integer, the absolute value of $N_s(i)$ is the number of turns of the first detection coil in $i^{th}$ one of the magnetic sensor sections of the first group 410, and the sign of the $N_s(i)$ is indicative of a winding direction of the first detection coil in the $i^{th}$ one of the magnetic sensor sections of the first group 410. The magnetic sensor sections can be numbered for example so that the index i increases in the counterclockwise direction. In figure 4a, the index is presented with boldface numbers. The first detection coils are advantageously series connected. The first excitation coils can be configured according to the earlier presented equation 2:

$$N_e(i) = (-1)^i N_{e0}, \; i = 1, \ldots, N,$$

where $N_{e0}$ is a predetermined integer, the absolute value of $N_e(i)$ is the number of turns of the first excitation coil in $i^{th}$ one of the magnetic sensor sections of the first group 410, and the sign of $N_e(i)$ is indicative of a winding direction of the first excitation coil in the $i^{th}$ one of the magnetic sensor sections of the first group 410. The first excitation coils are advantageously series connected. The second group 411 of successively placed magnetic sensor sections is advantageously like the first group of successively placed magnetic sensor sections.

Figure 4b show exemplifying first and second alternating output signals 431 and 432 simulated for the variable reluctance resolver illustrated in figure 4a when the variable reluctance resolver has the following parameters and operational data:

| | |
|---|---|
| rotational speed: | 1000 rpm |
| rotor inner diameter Dri: | 195 mm |
| stator inner diameter Dsi: | 242 mm |
| axial i.e. z-directional length: | 7 mm |
| minimum air-gap length: | 1.0 mm |
| maximum air-gap length: | 7.4 mm |
| voltage of the series connection of the first and second excitation coils: | 7.0 $V_{RMS}$ |
| current in the first and second excitation coils: | 1.5 $A_{RMS}$ |
| frequency in the first and second excitation coils: | 10 kHz |

the total number of turns in the series connection of the first and second excitation coils: 168, i.e. 14 turns on each of the 12 magnetic core elements, and

the number of turns in the first and second detection coils: 200 or 100 per a magnetic core element so that, for each of the first and second groups 410 and 411, the first magnetic core element in the counterclockwise direction has 100 turns, the second magnetic core element has 200 turns, the third magnetic core element has 100 turns, the fourth magnetic core element has 100 turns, the fifth magnetic core element has 200 turns, and the sixth magnetic core element has 100 turns. The winding directions of the first and second detection coils as well as the winding directions of the first and second excitation coils are changed in each second magnetic core element

material of the electrically and/or magnetically conductive elements: aluminum.

The winding dimensions are the following:

the copper space factor is assumed to be 0.4, and
the copper area in each magnetic sensor section is $0.4 \times 17$ mm$^2$ = 6.8 mm$^2$ so that 3 mm$^2$ belongs to an excitation coil and 3.8 mm$^2$ to a detection coil.

Figure 4c show an envelope 433 of the first alternating output signal 431 shown in figure 4b and an envelope 434 of the second alternating output signal 432 shown in figure 4b.

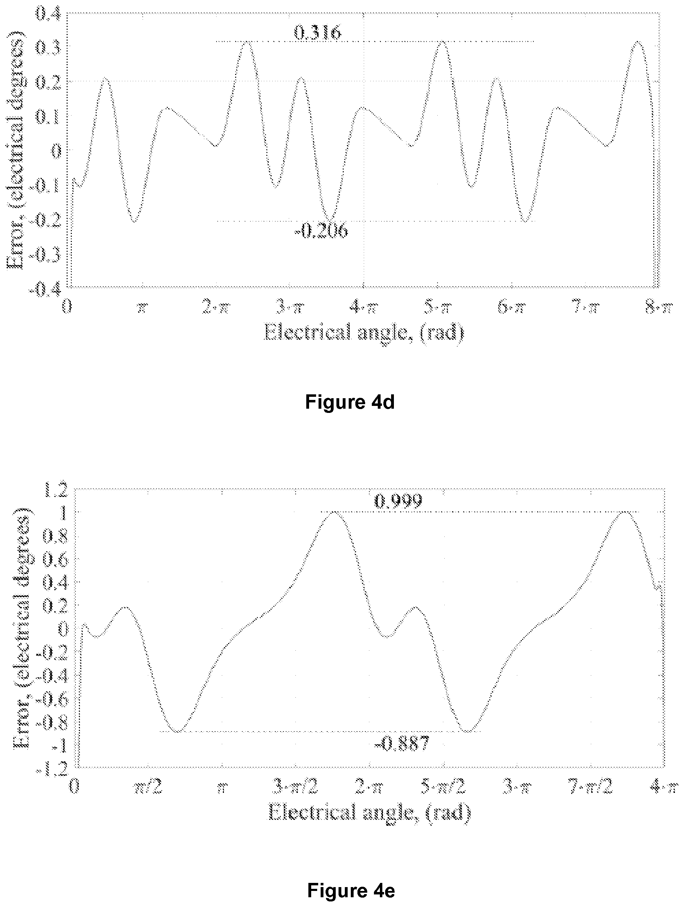

Figure 4d shows a positioning error related to the variable reluctance position sensor illustrated in figure 4a. The peak-to-peak positioning error is about 0.52 electrical degrees.

Figure 4e shows a positioning error related to a variable reluctance position sensor which is otherwise like the variable reluctance position sensor illustrated in figure 4a, but which does not comprise the electrically and/or magnetically conductive elements 416-418. In this exemplifying case, the peak-to-peak positioning error is about 1.9 electrical degrees which is notably greater than the peak-to-peak positioning error related to the variable reluctance position sensor illustrated in figure 4a.

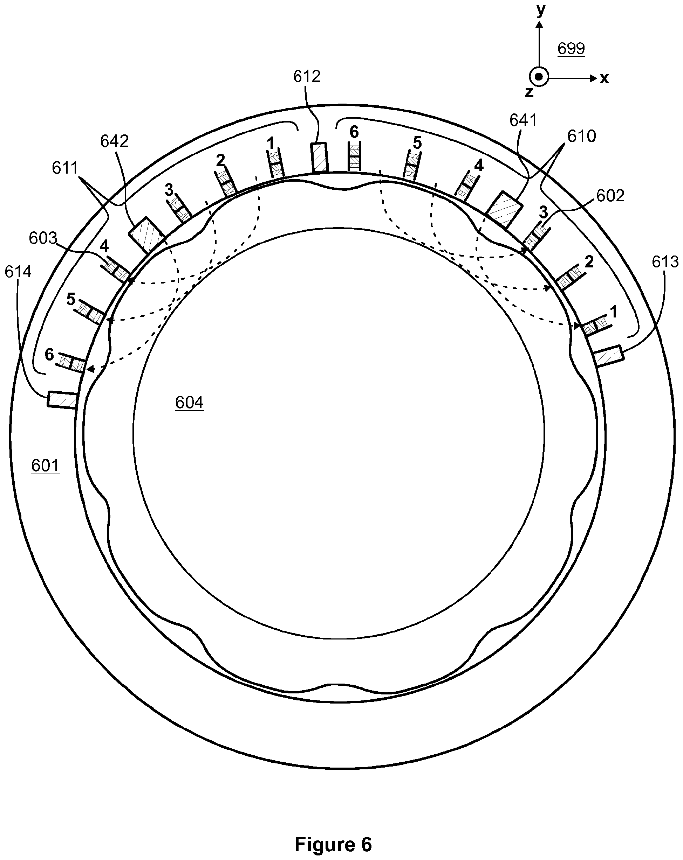

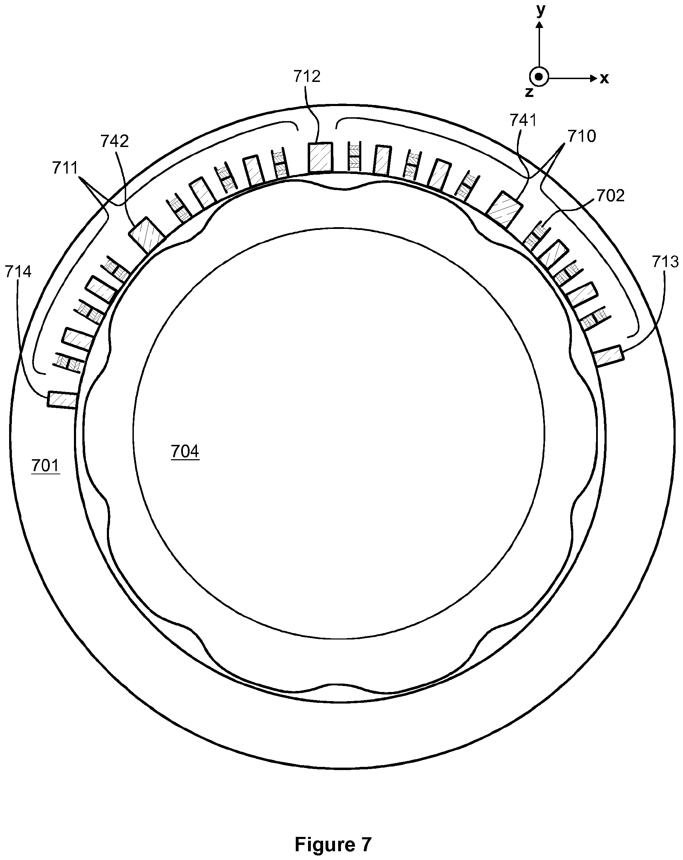

In the exemplifying variable reluctance position sensors illustrated in figures 1, 2a, 2b, 3a, 3c, 4a and 5, adjacent ones of the magnetic sensor sections within each of the first and second groups are displaced with respect to each other in the direction of movement of the airgap surface by the spatial meandering period/N, where N is the number of the magnetic sensor sections in each of the first and second groups. As illustrated below with reference to figures 6 and 7 this is however not the only possible choice.

Figure 6 illustrates a variable reluctance position sensor according to an exemplifying and non-limiting embodiment. The variable reluctance position sensor comprises a first element 601 and a second element 604. In this exemplifying case, the variable reluctance position sensor is a variable reluctance resolver for measuring a rotational angle of the second element 604, i.e. a rotor, with respect to the first element 601, i.e. a stator. The rotational axis of the second element 604, i.e. the rotor, is parallel with the z-axis of a coordinate system 699. The first element 601, i.e. the stator, comprises a plurality of magnetic sensor sections that are placed along an arc of a geometric circle in a direction of the airgap surface of the rotor. The second element 604, i.e. the rotor, comprises an air-gap surface that has a periodically meandering profile with ten spatial meandering periods, i.e. the rotor comprises ten mechanical poles. First ones of the magnetic sensor sections constitute a first group 610 of successively placed magnetic sensor sections and second ones of the magnetic sensor sections constitute a second group 611 of successively placed magnetic sensor sections. The first ones of the magnetic sensor sections comprise first excitation coils and first detection coils configured to produce a first alternating output signal when alternating excitation signal is supplied to the first excitation coils. Correspondingly, the second ones of the magnetic sensor sections comprise second excitation coils and second detection coils configured to produce a second alternating output signal when alternating excitation signal is supplied to the second excitation coils. The first group 610 of successively placed magnetic sensor sections and the second group 611 of successively placed magnetic sensor sections are mechanically arranged so that the second group 611 is displaced with respect to the first group 610 in the direction of movement of the airgap surface, i.e. in the circumferential direction, by C × the spatial meandering period, where C is a non-integer number. In the exemplifying variable reluctance resolver illustrated in figure 6, C = 2¼. In other words, the second group 611 is displaced with respect to the first group 610 by 90 electrical degrees + 720 electrical degrees i.e. by 810 electrical degrees which is 81 mechanical degrees. With this displacement between the first and second groups 610 and 611, the phase-shift between the envelopes of the first and second alternating output signals is substantially 90 degrees.

The arrangement of the magnetic sensor sections shown in figure 6 can be derived from the arrangement of the magnetic sensor sections shown in figure 4a so that the magnetic sensor sections indexed as 1, 3, and 5 in the first group 410 shown in figure 4a are shifted by one meandering period in the clockwise direction and the magnetic sensor sections indexed as 2, 4, and 6 in the second group 411 shown in figure 4a are shifted by one meandering period in the counterclockwise direction. The shifting is depicted with dashed line arrows in figure 6. As a corollary, adjacent ones of the magnetic sensor sections of each of the first and second groups 610 and 611 shown in figure 6 are displaced with respect to each other in the direction of movement of the airgap surface by 2 × the spatial meandering period/N except that the displacement between the middle ones of the magnetic sensor sections within each of the first and second groups 610 and 611 is 3 × the spatial meandering period/N, where N is the number of the magnetic sensor sections in each of the first and second groups so that N = 2M, where M is an integer i.e. N is even. In this exemplifying case N = 6.

In the exemplifying variable reluctance position sensor illustrated in figure 6, the first detection coils can be configured according to the following equations:

$$N_{aux}(i) = N_{s0} \sin [2\pi (i - \tfrac{1}{2})/2M], \ i = 1, \ldots, 2M,$$

$$N_s(i) = (-1)^i N_{aux}(2i - 1) \text{ and } N_s(i + M) = (-1)^{(i + M)} N_{aux}(2i), \ i = 1, \ldots, M,$$

where $N_{s0}$ is a predetermined integer, the absolute value of $N_s(i)$ is the number of turns of the first detection coil in $i^{th}$ one of the magnetic sensor sections of the first group 610 and the sign of the $N_s(i)$ is indicative of a winding direction of the first detection coil in the $i^{th}$ one of the magnetic sensor sections of the first group 610. The first detection coils are advantageously series connected. In figure 6, the index i of each magnetic sensor section is presented with a boldface number.

In the exemplifying variable reluctance position sensor illustrated in figure 4a, the first excitation coils can be configured according to the following equations:

$$N_e(i) = (-1)^i N_{e0}, \; i = 1, \ldots, N,$$

where $N_{e0}$ is a predetermined integer, the absolute value of $N_e(i)$ is the number of turns of the first excitation coil in $i^{th}$ one of the magnetic sensor sections of the first group 610, and the sign of $N_e(i)$ is indicative of a winding direction of the first excitation coil in the $i^{th}$ one of the magnetic sensor sections of the first group 610. The first excitation coils are advantageously series connected.

In the exemplifying variable reluctance position sensor illustrated in figure 6, the first element 601 comprises an electrically and/or magnetically conductive element 612 between the first and second groups 610 and 611 of successively placed magnetic sensor sections. Furthermore, the first element 601 comprises electrically and/or magnetically conductive elements 613 and 614 at the other ends of the first and second groups 610 and 611. Furthermore, the first element 601 comprises an electrically and/or magnetically conductive element 641 between the middle ones of the magnetic sensor sections within the first group 610 and an electrically and/or magnetically conductive element 642 between the middle ones of the magnetic sensor sections within the second group 611.

Figure 7 illustrates a variable reluctance position sensor according to an exemplifying and non-limiting embodiment. The variable reluctance position sensor illustrated in figure 7 is otherwise like the variable reluctance position sensor illustrated in figure 6, but the first element 701 comprises electrically and/or magnetically conductive elements placed between the magnetic sensor sections so that the magnetic sensor sections and the electrically and/or magnetically conductive elements are alternately in the direction of movement of the airgap surface of the first element 704. Furthermore, the first element 701 comprises electrically and/or magnetically conductive elements 713 and 714 at ends of the first and second groups 710 and 711 of magnetic sensor sections. In figure 7, three of the magnetic sensor sections that are between adjacent ones of the magnetic sensor sections are denoted with references 712, 741, and 742.

In the exemplifying variable reluctance position sensors illustrated in figures 1, 2a, 2b, 3a, 3c, 4a, 5, 6 and 7, each of the magnetic sensor sections has a magnetic core element that is separate with respect to magnetic core elements of other ones of the magnetic sensor sections. Each magnetic core element comprises material whose relative magnetic permeability $\mu$ is greater than one. The material is advantageously ferromagnetic material. Each magnetic core element may comprise e.g. a stack of electrically insulated steel sheets, ferrite, or soft magnetic composite. In the exemplifying variable reluctance position sensors illustrated in figures 1, 2a, 2b, 3a, 3c, 4a, 5, 6 and 7 each of the magnetic sensor sections has a H-shaped magnetic core element. It is also possible that each magnetic sensor section has a U-shaped magnetic core element, a C-shaped magnetic core element, an E-shaped magnetic core element, or a magnetic core element having some other suitable shape. Furthermore, it is also possible that two or more of the magnetic sensor sections have a common magnetic core that has teeth and a yoke connected to the teeth.

The specific examples provided in the description given above should not be construed as limiting the scope and/or the applicability of the appended claims. List and groups of examples provided in the description given above are not exhaustive unless otherwise explicitly stated.

## Claims

1. A variable reluctance position sensor comprising:

    - a first element (101, 201, 301, 401, 501, 601, 701) comprising a plurality of magnetic sensor sections (102, 103, 202, 203, 302, 303), and
    - a second element (104, 204, 304, 404, 604, 704) moveable with respect to the first element and comprising an air-gap surface (105, 205, 305, 405) having a periodically meandering profile with at least two spatial meandering periods,

    wherein:

    - each of the magnetic sensor sections is configured to conduct a magnetic flux to and from the second element via the airgap surface of the second element, and
    - first ones of the magnetic sensor sections comprise first excitation coils (106) and first detection coils (107) configured to produce a first alternating output signal when alternating excitation signal is supplied to the first excitation coils, and

- second ones of the magnetic sensor sections comprise second excitation coils (108) and second detection coils (109) configured to produce a second alternating output signal when alternating excitation signal is supplied to the second excitation coils, amplitudes of the first and second alternating output signals being dependent on a position of the second element with respect to the first element so that envelopes of the first and second alternating output signals have a phase-shift with respect to each other,

**characterized in that** the first ones of the magnetic sensor sections constitute a first group (110, 210, 310, 410, 510, 610, 710) of successively placed magnetic sensor sections and the second ones of the magnetic sensor sections constitute a second group (111, 211, 311, 411, 511, 611, 711) of successively placed magnetic sensor sections so that the second group of successively placed magnetic sensor sections is displaced ($\alpha$) with respect to the first group of successively placed magnetic sensor sections in a direction of movement of the airgap surface by C $\times$ the spatial meandering period, where C is a non-integer number.

2. A variable reluctance position sensor according to claim 1, wherein the first group (110, 210, 310, 410) of successively placed magnetic sensor sections covers less than the spatial meandering period, and the second group (111, 211, 311, 411) of successively placed magnetic sensor sections covers less than the spatial meandering period.

3. A variable reluctance position sensor according to claim 1 or 2, wherein adjacent ones of the magnetic sensor sections within each of the first and second groups (110, 210, 310, 410, 511, 111, 211, 311, 411, 511) are displaced with respect to each other in the direction of movement of the airgap surface by the spatial meandering period/N, where N is a number of the magnetic sensor sections of each of the first and second groups.

4. A variable reluctance position sensor according to claim 3, wherein the magnetic sensor sections of the first group (110, 210, 310, 410, 510) of successively placed magnetic sensor sections are configured according to equations:

$$N_s(i) = (-1)^i \, N_{s0} \sin [2\pi \, (i - \tfrac{1}{2})/N], \; i = 1, \ldots, N,$$

where $N_{s0}$ is a predetermined integer, an absolute value of $N_s(i)$ is a number of turns of the first detection coil in $i^{th}$ one of the magnetic sensor sections of the first group, and a sign of the $N_s(i)$ is indicative of a winding direction of the first detection coil in the $i^{th}$ one of the magnetic sensor sections of the first group.

5. A variable reluctance position sensor according to claim 1, wherein adjacent ones of the magnetic sensor sections within each of the first and second groups (610, 611) are displaced with respect to each other in the direction of movement of the airgap surface by 2 $\times$ the spatial meandering period/N except that a displacement between middle ones of the magnetic sensor sections within each of the first and second groups is 3 $\times$ the spatial meandering period/N, where N is the number of the magnetic sensor sections of each of the first and second groups so that N = 2M, where M is an integer.

6. A variable reluctance position sensor according to claim 5, wherein the magnetic sensor sections of the first group (610) of successively placed magnetic sensor sections are configured according to equations:

$$N_{aux}(i) = N_{s0} \sin [2\pi \, (i - \tfrac{1}{2})/2M], \; i = 1, \ldots, 2M,$$

$$N_s(i) = (-1)^i \, N_{aux}(2i - 1) \text{ and } N_s(i + M) = (-1)^{(i + M)} \, N_{aux}(2i), \; i = 1, \ldots, M,$$

where $N_{s0}$ is a predetermined integer, an absolute value of $N_s(i)$ is a number of turns of the first detection coil in $i^{th}$ one of the magnetic sensor sections of the first group, and a sign of the $N_s(i)$ is indicative of a winding direction of the first detection coil in the $i^{th}$ one of the magnetic sensor sections of the first group.

7. A variable reluctance position sensor according to claim 4 or 6, wherein:

$$N_e(i) = (-1)^i \, N_{e0}, \; i = 1, \ldots, N,$$

where N is the number of the magnetic sensor sections of the first group, $N_{e0}$ is a predetermined integer, an absolute

value of $N_e(i)$ is a number of turns of the first excitation coil in $i^{th}$ one of the magnetic sensor sections of the first group, and a sign of $N_e(i)$ is indicative of a winding direction of the first excitation coil in the $i^{th}$ one of the magnetic sensor sections of the first group.

8. A variable reluctance position sensor according to claim 1, wherein the second group (111, 211, 311, 411, 511, 611, 711) of successively placed magnetic sensor sections is like the first group (110, 210, 310, 410, 510, 610, 710) of successively placed magnetic sensor sections.

9. A variable reluctance position sensor according to any one of claims 1-8, wherein the variable reluctance position sensor is a variable reluctance resolver in which the first element (101, 201, 401) is a stator and the second element (104, 204, 404) is a rotor that is rotatable with respect to the stator, the magnetic sensor sections (102, 202) of the first group (110, 210, 410) being successively along an arc of a geometric circle in a circumferential direction, the magnetic sensor sections (103, 203) of the second group (111, 211, 411) being successively along the arc of the geometric circle in the circumferential direction, and the position of the second element with respect to the first element being a rotation angle ($\theta$) of the rotor with respect to the stator.

10. A variable reluctance position sensor according to any one of claims 1-8, wherein the variable reluctance position sensor is a variable reluctance linear position sensor configured measure a position of the second element (304) with respect to the first element (301) in a direction of a linear movement of the first element with respect to the second element.

11. A variable reluctance position sensor according to any one of claims 1-10, wherein each of the magnetic sensor sections (102, 103) has a magnetic core element being separate with respect to magnetic core elements of other ones of the magnetic sensor sections.

12. A variable reluctance position sensor according to claim 11, wherein the first element (101, 401, 501, 601, 701) comprises one or more electrically and/or magnetically conductive elements (112, 113, 416, 512, 612, 712) between the first and second groups of successively placed magnetic sensor sections.

13. A variable reluctance position sensor according to claim 11 or 12, wherein the first element (101, 401, 501, 601, 701) comprises one or more electrically and/or magnetically conductive elements (114, 417, 513, 613, 713) at an end of the first group (110, 410) of successively placed magnetic sensor sections facing away from the second group of successively placed magnetic sensor sections, and one or more electrically and/or magnetically conductive elements (115, 418, 514, 614, 714) at an end of the second group (111, 411) of successively placed magnetic sensor sections facing away from the first group of successively placed magnetic sensor sections.

14. A variable reluctance position sensor according to any one of claims 11-13, wherein the first element (701) comprises electrically and/or magnetically conductive elements (712, 741, 742) placed between the magnetic sensor sections so that the magnetic sensor sections and the electrically and/or magnetically conductive elements are alternately in the direction of movement of the airgap surface of the first element.

15. A variable reluctance position sensor according to any one of claims 1-14, wherein C = ¼ + an integer.


**Patentansprüche**

1. Positionssensor mit variabler Reluktanz, aufweisend:

> - ein erstes Element (101, 201, 301, 401, 501, 601, 701), das eine Mehrzahl von magnetischen Sensorabschnitten (102, 103, 202, 203, 302, 303) aufweist, und
> - ein zweites Element (104, 204, 304, 404, 604, 704), das relativ zu dem ersten Element beweglich ist und eine Luftspaltoberfläche (105, 205, 305, 405) mit einem periodisch mäanderförmigen Profil mit mindestens zwei räumlichen mäandernden Perioden aufweist,

wobei:

> - jeder der magnetischen Sensorabschnitte dazu gestaltet ist, über die Luftspaltoberfläche des zweiten Elements einen magnetischen Fluss zu und von dem zweiten Element zu leiten, und

- erste der magnetischen Sensorabschnitte erste Erregerspulen (106) und erste Detektionsspulen (107), die dazu gestaltet sind, ein erstes alternierendes Ausgangssignal zu erzeugen, wenn den ersten Erregerspulen ein alternierendes Erregersignal zugeführt wird, aufweisen, und

- zweite der magnetischen Sensorabschnitte zweite Erregerspulen (108) und zweite Detektionsspulen (109), die dazu gestaltet sind, ein zweites alternierendes Ausgangssignal erzeugen, wenn den zweiten Erregerspulen ein alternierendes Erregersignal zugeführt wird, aufweisen, wobei Amplituden des ersten und des zweiten alternierenden Ausgangssignals von einer Position des zweiten Elements in Bezug auf das erste Element abhängig sind, so dass Hüllkurven des ersten und des zweiten alternierenden Ausgangssignals eine Phasenverschiebung in Bezug zueinander aufweisen,

**dadurch gekennzeichnet, dass** die ersten der magnetischen Sensorabschnitte eine erste Gruppe (110, 210, 310, 410, 510, 610, 710) nacheinander angeordneter magnetischer Sensorabschnitte bilden und die zweiten der magnetischen Sensorabschnitte eine zweite Gruppe (111, 211, 311, 411, 511, 611, 711) nacheinander angeordneter magnetischer Sensorabschnitte bilden, so dass die zweite Gruppe nacheinander angeordneter magnetischer Sensorabschnitte gegenüber der ersten Gruppe nacheinander angeordneter magnetischer Sensorabschnitte in Bewegungsrichtung der Luftspaltoberfläche um C $\times$ die räumliche Mäanderperiode versetzt ($\alpha$) ist, wobei C eine nicht ganze Zahl ist.

2. Positionssensor mit variabler Reluktanz nach Anspruch 1, wobei die erste Gruppe (110, 210, 310, 410) nacheinander angeordneter magnetischer Sensorabschnitte weniger als die räumliche Mäanderperiode abdeckt und die zweite Gruppe (111, 211, 311, 411) nacheinander angeordneter magnetischer Sensorabschnitte weniger als die räumliche Mäanderperiode abdeckt.

3. Positionssensor mit variabler Reluktanz nach Anspruch 1 oder 2, wobei benachbarte der magnetischen Sensorabschnitte innerhalb jeder der ersten und der zweiten Gruppe (110, 210, 310, 410, 511, 111, 211, 311, 411, 511) in Bewegungsrichtung der Luftspaltoberfläche um die räumliche Mäanderperiode/N zueinander versetzt sind, wobei N die Anzahl der magnetischen Sensorabschnitte jeder der ersten und der zweiten Gruppe ist.

4. Positionssensor mit variabler Reluktanz nach Anspruch 3, wobei die magnetischen Sensorabschnitte der ersten Gruppe (110, 210, 310, 410, 510) nacheinander angeordneter magnetischer Sensorabschnitte gemäß den Gleichungen gestaltet sind:

$$N_s(i) = (-1)^i N_{s0} \sin\left[2\pi(i - 1/2)/N\right], \ i = 1, \ldots, N,$$

wobei $N_{s0}$ eine vorgegebene ganze Zahl ist, ein Absolutwert von $N_s(i)$ eine Anzahl von Windungen der ersten Detektionsspule in einem der magnetischen Sensorabschnitte der ersten Gruppe ist, und das Vorzeichen von $N_s(i)$ eine Wicklungsrichtung der ersten Detektionsspule im i-ten der magnetischen Sensorabschnitte der ersten Gruppe angibt.

5. Positionssensor mit variabler Reluktanz nach Anspruch 1, wobei benachbarte der magnetischen Sensorabschnitte innerhalb jeder der ersten und der zweiten Gruppe (610, 611) in Bewegungsrichtung der Luftspaltoberfläche um 2 $\times$ die räumliche Mäanderperiode/N relativ zueinander versetzt sind, mit der Ausnahme, dass eine Verschiebung zwischen mittleren der magnetischen Sensorabschnitte innerhalb jeder der ersten und zweite Gruppe 3 $\times$ die räumliche Mäanderperiode/N beträgt, wobei N die Anzahl der magnetischen Sensorabschnitte jeder der ersten und der zweiten Gruppe ist, so dass N = 2M ist, wobei M eine ganze Zahl ist.

6. Positionssensor mit variabler Reluktanz nach Anspruch 5, wobei die magnetischen Sensorabschnitte der ersten Gruppe (610) nacheinander angeordneter magnetischer Sensorabschnitte gemäß den Gleichungen gestaltet sind:

$$N_{aux}(i) = N_{so} \sin\left[2\pi(i - 1/2)/2M\right], i = 1, \ldots, 2M,$$

$$N_s(i) = (-1)^i N_{aux}(2i - 1) \ \text{and} \ N_s(i + M) = (-1)^{(i+M)} N_{aux}(2i),$$
$$i = 1, \ldots, M,$$

wobei $N_{s0}$ eine vorgegebene ganze Zahl ist, ein Absolutwert von $N_s(i)$ eine Anzahl von Windungen der ersten Detektionsspule in einem der magnetischen Sensorabschnitte der ersten Gruppe ist, und das Vorzeichen von $N_s(i)$ eine Wicklungsrichtung der ersten Detektionsspule im i-ten der magnetischen Sensorabschnitte der ersten Gruppe angibt.

7. Positionssensor mit variabler Reluktanz nach Anspruch 4 oder 6, wobei:

$$N_e(i) = (-1)^i N_{e0}, i = 1, \dots, N$$

wobei N die Anzahl der magnetischen Sensorabschnitte der ersten Gruppe ist, $N_{e0}$ eine vorgegebene ganze Zahl ist, ein Absolutwert von $N_e(i)$ die Anzahl der Windungen der ersten Erregerspule in einem der magnetischen Sensorabschnitte der ersten Gruppe ist, und das Vorzeichen von $N_e(i)$ eine Wicklungsrichtung der ersten Erregerspule im i-ten der magnetischen Sensorabschnitte der ersten Gruppe angibt.

8. Positionssensor mit variabler Reluktanz nach Anspruch 1, wobei die zweite Gruppe (111, 211, 311, 411, 511, 611, 711) nacheinander angeordneter magnetischer Sensorabschnitte wie die erste Gruppe (110, 210, 310, 410, 510, 610, 710) nacheinander angeordneter magnetischer Sensorabschnitten ist.

9. Positionssensor mit variabler Reluktanz nach einem der Ansprüche 1-8, wobei der Positionssensor mit variabler Reluktanz ein Resolver mit variabler Reluktanz ist, bei dem das erste Element (101, 201, 401) ein Stator ist und das zweite Element (104, 204, 404) ein gegenüber dem Stator drehbarer Rotor ist, wobei die magnetischen Sensorabschnitte (102, 202) der ersten Gruppe (110, 210, 410) entlang eines geometrischen Kreisbogens in Umfangsrichtung nacheinander angeordnet sind, wobei die magnetischen Sensorabschnitte (103, 203) der zweiten Gruppe (111, 211, 411) entlang des geometrischen Kreisbogens in der Umfangsrichtung nacheinander angeordnet sind, und die Position des zweiten Elements in Bezug auf das erste Element ein Drehwinkel ($\theta$) des Rotors in Bezug auf den Stator ist.

10. Positionssensor mit variabler Reluktanz nach einem der Ansprüche 1-8, wobei der Positionssensor mit variabler Reluktanz ein linearer Positionssensor mit variabler Reluktanz ist, der dazu gestaltet ist, eine Position des zweiten Elements (304) in Bezug auf das erste Element (301) in einer Richtung einer linearen Bewegung des ersten Elements in Bezug auf das zweite Element zu messen.

11. Positionssensor mit variabler Reluktanz nach einem der Ansprüche 1-10, wobei jeder der magnetischen Sensorabschnitte (102, 103) ein Magnetkernelement aufweist, das in Bezug auf Magnetkernelemente anderer magnetischer Sensorabschnitte getrennt ist.

12. Positionssensor mit variabler Reluktanz nach Anspruch 11, wobei das erste Element (101, 401, 501, 601, 701) eines oder mehrere elektrisch und/oder magnetisch leitende Elemente (112, 113, 416, 512, 612, 712) zwischen der ersten und zweiten Gruppe nacheinander angeordneter magnetischer Sensorabschnitte aufweist.

13. Positionssensor mit variabler Reluktanz nach Anspruch 11 oder 12, wobei das erste Element (101, 401, 501, 601, 701) eines oder mehrere elektrisch und/oder magnetisch leitende Elemente (114, 417, 513, 613, 713) an einem Ende der ersten Gruppe (110, 410) nacheinander angeordneter magnetischer Sensorabschnitte, die von der zweiten Gruppe nacheinander angeordneter magnetischer Sensorabschnitte abgewandt sind, und eines oder mehrere elektrisch und/oder magnetisch leitende Elemente (115, 418, 514, 614, 714) an einem Ende der zweiten Gruppe (111, 411) nacheinander angeordneter magnetischer Sensorabschnitte, die von der ersten Gruppe nacheinander angeordneter magnetischer Sensorabschnitte abgewandt sind, aufweist.

14. Positionssensor mit variabler Reluktanz nach einem der Ansprüche 11-13, wobei das erste Element (701) elektrisch und/oder magnetisch leitende Elemente (712, 741, 742) aufweist, die zwischen den magnetischen Sensorabschnitten angeordnet sind, so dass die magnetischen Sensorabschnitte und die elektrisch und/oder magnetisch leitenden Elemente in Bewegungsrichtung der Luftspaltoberfläche des ersten Elements abwechselnd liegen.

15. Positionssensor mit variabler Reluktanz nach einem der Ansprüche 1-14, wobei C = 1/4 + eine ganze Zahl ist.

**Revendications**

1. Capteur de position à réluctance variable comprenant :

   - un premier élément (101, 201, 301, 401, 501, 601, 701) comprenant une pluralité de sections de capteur magnétique (102, 103, 202, 203, 302, 303), et
   - un second élément (104, 204, 304, 404, 604, 704) mobile par rapport au premier élément et comprenant une surface d'entrefer (105, 205, 305, 405) ayant un profil sinueux périodique avec au moins deux périodes sinueuses spatiales,

   dans lequel :

   - chacune des sections de capteur magnétique est configurée pour conduire un flux magnétique vers et depuis le second élément par le biais de la surface d'entrefer du second élément, et
   - des premières des sections de capteur magnétique comprennent des premières bobines d'excitation (106) et des premières bobines de détection (107) configurées pour produire un premier signal de sortie alternatif lorsqu'un signal d'excitation alternatif est fourni aux premières bobines d'excitation, et
   - des secondes des sections de capteur magnétique comprennent des secondes bobines d'excitation (108) et des secondes bobines de détection (109) configurées pour produire un second signal de sortie alternatif lorsqu'un signal d'excitation alternatif est fourni aux secondes bobines d'excitation, des amplitudes des premier et second signaux de sortie alternatifs étant dépendantes d'une position du second élément par rapport au premier élément de façon à ce que des enveloppes des premier et second signaux de sortie alternatifs aient un décalage de phase l'une par rapport à l'autre,

   **caractérisé en ce que** les premières des sections de capteur magnétique constituent un premier groupe (110, 210, 310, 410, 510, 610, 710) de sections de capteur magnétique placées successivement et les secondes des sections de capteur magnétique constituent un second groupe (111, 211, 311, 411, 511, 611, 711) de sections de capteur magnétique placées successivement de façon à ce que le second groupe de sections de capteur magnétique placées successivement soit déplacé ($\alpha$) par rapport au premier groupe de sections de capteur magnétique placées successivement dans une direction de mouvement de la surface d'entrefer de C x la période sinueuse spatiale, où C est un nombre non entier.

2. Capteur de position à réluctance variable selon la revendication 1, dans lequel le premier groupe (110, 210, 310, 410) de sections de capteur magnétique placées successivement couvre moins que la période sinueuse spatiale, et le second groupe (111, 211, 311, 411) de sections de capteur magnétique placées successivement couvre moins que la période sinueuse spatiale.

3. Capteur de position à réluctance variable selon la revendication 1 ou 2, dans lequel des unes adjacentes des sections de capteur magnétique à l'intérieur de chacun des premier et second groupes (110, 210, 310, 410, 511, 111, 211, 311, 411, 511) sont déplacées l'une par rapport à l'autre dans la direction de mouvement de la surface d'entrefer par la période sinueuse spatiale/N, où N est un nombre des sections de capteur magnétique de chacun des premier et second groupes.

4. Capteur de position à réluctance variable selon la revendication 3, dans lequel les sections de capteur magnétique du premier groupe (110, 210, 310, 410, 510) de sections de capteur magnétique placées successivement sont configurées selon des équations :

$$N_s(i) = (-1)^i \, N_s0 \, \sin\left[2\pi\,(i - 1/2)/N\right], \quad i = 1, \ldots, N,$$

   où $N_s0$ est un entier prédéterminé, une valeur absolue de $N_s(i)$ est un nombre de tours de la première bobine de détection dans une i^ème des sections de capteur magnétique du premier groupe, et un signe de $N_s(i)$ indique une direction de bobinage de la première bobine de détection dans l'une i^ème des sections de capteur magnétique du premier groupe.

5. Capteur de position à réluctance variable selon la revendication 1, dans lequel des unes adjacentes des sections de capteur magnétique à l'intérieur de chacun des premier et second groupes (610, 611) sont déplacées l'une par rapport à l'autre dans la direction de mouvement de la surface d'entrefer de 2 x la période sinueuse spatiale/N sauf qu'un déplacement entre des centrales des sections de capteur magnétique à l'intérieur de chacun des premier et second groupes est de 3 x la période sinueuse spatiale/N, où N est le nombre de sections de capteur magnétique de chacun des premier et second groupes de telle façon que N = 2M, où M est un nombre entier.

6.  Capteur de position à réluctance variable selon la revendication 5, dans lequel les sections de capteur magnétique du premier groupe (610) de sections de capteur magnétique placées successivement sont configurées selon des équations :

$$N_{aux}(i) = (-1)^i N_{s0} \sin [2\pi (i - 1/2)/2M], \quad i = 1, \ldots, 2M,$$

$N_s(i) = (-1)^i N_{aux}(2i - 1)$ et $N_s(i + M) = (-1)^{(i + M)} N_{aux}(2i)$, i = 1, ..., M, où $N_{s0}$ est un entier prédéterminé, une valeur absolue de $N_s(i)$ est un nombre de tours de la première bobine de détection dans une i$^{ème}$ des sections de capteur magnétique du premier groupe, et un signe de $N_s(i)$ indique une direction de bobinage de la première bobine de détection dans l'une i$^{ème}$ des sections de capteur magnétique du premier groupe.

7.  Capteur de position à réluctance variable selon la revendication 4 ou 6, dans lequel :

$$N_e(i) = (-1)^i N_e0, \quad i = 1, \ldots, N,$$

où N est le nombre de sections de capteur magnétique du premier groupe, $N_{e0}$ est un entier prédéterminé, une valeur absolue de $N_e(i)$ est un nombre de tours de la première bobine de détection dans une i$^{ème}$ des sections de capteur magnétique du premier groupe, et un signe de $N_e(i)$ indique une direction de bobinage de la première bobine de détection dans l'une i$^{ème}$ des sections de capteur magnétique du premier groupe.

8.  Capteur de position à réluctance variable selon la revendication 1, dans lequel le second groupe (111, 211, 311, 411, 511, 611, 711) de sections de capteur magnétique placées successivement est comme le premier groupe (110, 210, 310, 410, 510, 610, 710) de sections de capteur magnétique placées successivement.

9.  Capteur de position à réluctance variable selon l'une quelconque des revendications 1 - 8, dans lequel le capteur de position à réluctance variable est un résolveur à réluctance variable dans lequel le premier élément (101, 201, 401) est un stator et le second élément (104, 204, 404) est un rotor qui peut tourner par rapport au stator, les sections de capteur magnétique (102, 202) du premier groupe (110, 210, 410) étant successivement le long d'un arc d'un cercle géométrique dans une direction circonférentielle, les sections de capteur magnétique (103, 203) du second groupe (111, 211, 411) étant successivement le long de l'arc du cercle géométrique dans la direction circonférentielle, et la position du second élément par rapport au premier élément étant un angle de rotation (θ) du rotor par rapport au stator.

10. Capteur de position à réluctance variable selon l'une quelconque des revendications 1 - 8, dans lequel le capteur de position à réluctance variable est un capteur de position linéaire à réluctance variable configuré pour mesurer une position du second élément (304) par rapport au premier élément (301) dans une direction d'un mouvement linéaire du premier élément par rapport au second élément.

11. Capteur de position à réluctance variable selon l'une quelconque des revendications 1 - 10, dans lequel chacune des sections de capteur magnétique (102, 103) présente un élément de noyau magnétique séparé par rapport aux éléments de noyau magnétique d'autres des sections de capteur magnétique.

12. Capteur de position à réluctance variable selon la revendication 11, dans lequel le premier élément (101, 401, 501, 601, 701) comprend un ou plusieurs élément(s) conducteur(s) électrique et/ou magnétique (112, 113, 416, 512, 612, 712) entre les premier et second groupes de sections de capteur placées successivement.

13. Capteur de position à réluctance variable selon la revendication 11 ou 12, dans lequel le premier élément (101, 401, 501, 601, 701) comprend un ou plusieurs élément(s) conducteur(s) électrique et/ou magnétique (114, 417, 513, 613, 713) à une extrémité du premier groupe (110, 410) de sections de capteur placées successivement orientées à distance du second groupe de sections de capteur placées successivement, et un ou plusieurs élément(s) conducteur(s) électrique et/ou magnétique (115, 418, 514, 614, 714) à une extrémité du second groupe (111, 411) de sections de capteur placées successivement orientées à distance du premier groupe de sections de capteur placées successivement.

14. Capteur de position à réluctance variable selon l'une quelconque des revendications 11 - 13, dans lequel le premier élément (701) comprend des éléments conducteurs électriques et/ou magnétiques (712, 741, 742) placés entre les sections de capteur magnétique de façon à ce que les sections de capteur magnétique et les éléments conducteurs électriques et/ou magnétiques soient alternativement dans la direction de mouvement de la surface d'entrefer du premier élément.

15. Capteur de position à réluctance variable selon l'une quelconque des revendications 1 - 14, dans lequel C = 1/4 + un entier.

**Figure 1**

**Figure 2a**

**Figure 2b**

**Figure 3a**

**Figure 3b**

**Figure 4a**

**Figure 4b**

**Figure 4c**

**Figure 4d**

**Figure 4e**

**Figure 5**

**Figure 6**

**Figure 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130162243 A
- EP 3324523 A1
- US 2004007926 A1
- US 2019280537 A1